# EUROPEAN PATENT SPECIFICATION

(11) **EP 1 662 851 B1**
(45) Date of publication and mention of the grant of the patent: **03.09.2008**
(21) Application number: 05110402.4
(22) Date of filing: 07.11.2005
(51) Int. Cl.: H05K 7/20

(54) **Conditioning apparatus particularly for racks for electrical, electronic, telecommunications instruments or the like**
Klimaanlage, inbesondere für elektrische oder elektronische Baugruppenträger, Vermittlungsinstrumente oder dergleiche
Appareil de conditionnement d'air pour des baies électroniques ou électriques, des instruments de télécommunications ou encore leurs équivalents

(30) Priority: 30.11.2004 IT PD20040303
(43) Date of publication of application: 31.05.2006
(73) Proprietor: EMERSON NETWORK POWER S.R.L., 35028 Piove di Sacco (Padova) (IT)
(72) Inventor: Scattolin, Mario, 30037, SCORZE' VE (IT); Ranzato, Alberto, 35028, PIOVE DI SACCO PD (IT); Girotto, Carlo, 35020, MASERA' DI PADOVA PD (IT)
(74) Representative: Modiano, Micaela Nadia

(56) References cited:
- WO-A-02/37918
- WO-A-03/083631
- DE-A1- 10 210 418
- DE-U1- 8 702 065
- US-A1- 2005 061 013
- US-A1- 2005 217 299
- US-B1- 6 208 510

## Description

The present invention relates to a conditioning apparatus particularly for racks for electrical, electronic, telecommunications instruments or the like.

There is an increasing diffusion, together with computers and the use of internal and external data communications networks (the Internet, intranets, and the like), of supporting chassis for electrical, electronic and similar instruments which provide said computers (servers, auxiliary storage, and the like) and form the nodes of said networks (routers and the like), said chassis allowing to install and interface these devices in a compact space.

Chassis suitable for this purpose are known as "racks" and are widespread for example in the field of mobile telephony sites.

Racks are generally arranged inside cabinets, protected against dust and external agents in general.

The main problem linked to racks and to the cabinets that contain them relates to the overheating of the electronic instruments enclosed in the cabinet.

The increasing growth of mobile telephony, as well as of other fields of electronics and computer technology, has in fact led to an increase in the number of instruments supported by a same rack and packed within a same cabinet.

Problems therefore arise in connection to the dissipation of the heat generated inside the cabinet by these instruments and therefore to the appropriate conditioning of said cabinets.

For example, the increase in the number of racks within a site of a GSM/GPRS network and the birth of the UMTS network, characterized by a higher heat dispersal, in recent years has necessarily changed the conditioning requirements.

An excessive rise in temperature can in fact cause malfunctions of various kinds, up to the breakdown of the instruments contained in the cabinet.

At present, heat dissipation for such cabinets for racks is entrusted to the conditioning system of the room in which the cabinet is located and to the slots or grilles of the cabinet, which are suitable to allow the flow of air which arrives from the room between the instruments supported by the rack (or racks) contained in such room.

This cooling method is generally found to be insufficient, especially in the presence of the extremely compact servers of the latest generation, which generate extremely high consumptions per unit volume.

Regions which are stably too hot (so-called "hot spots") are accordingly generated within the rack cabinet and locally cause difficulties for electrical and electronic instruments, to the point of causing their failure.

WO 03/083631 discloses a cabinet for housing a vertical array of heart-producing units, that comprises a first plenum having a cooling fluid inlet communicating with an outlet whereby the inlet admits fluid to the first plenum in a substantially horizontal direction.

The aim of the present invention is to provide a conditioning apparatus particularly for racks for electrical, electronic, telecommunications instruments or the like, which is capable of solving the problems and drawbacks exhibited by cooling methods for known types of cabinets containing racks.

Within this aim, an object of the present invention is to provide a conditioning apparatus which renders the correct operation of the instruments contained in a rack cabinet independent of the operation of the conditioning system of the surrounding environment.

Another object of the present invention is to provide a conditioning apparatus which can be installed easily for a plurality of rack cabinets arranged close to each other.

Another object of the present invention is to provide a conditioning apparatus which prevents the formation of regions which are stably too hot within a rack cabinet.

Another object of the present invention is to provide a conditioning apparatus which can be manufactured cheaply with known systems and technologies.

In accordance with the invention, there is provided a conditioning apparatus particularly for racks for electrical, electronic, telecommunications instruments or the like, as defined in the appended claims.

Further characteristics and advantages of the invention will become better apparent from the following detailed description of three preferred but not exclusive embodiments thereof, illustrated by way of non-limiting example in the accompanying drawings, wherein:
Figure 1 is a front view of an apparatus according to the invention in a first embodiment;
Figure 2 is a partially sectional side view of an apparatus according to the invention in the first embodiment of Figure 1;
Figure 3 is another sectional side view of an apparatus according to the invention in its first embodiment;
Figure 4 is a front view of the invention in a second embodiment thereof;
Figure 5 is a front view of the invention in a third embodiment thereof;
Figure 6 is a schematic view of a modular arrangement of an apparatus according to the invention;
Figure 7 is a perspective view of a component of an apparatus according to the invention;
Figure 8 is a perspective view of another component of an apparatus according to the invention.

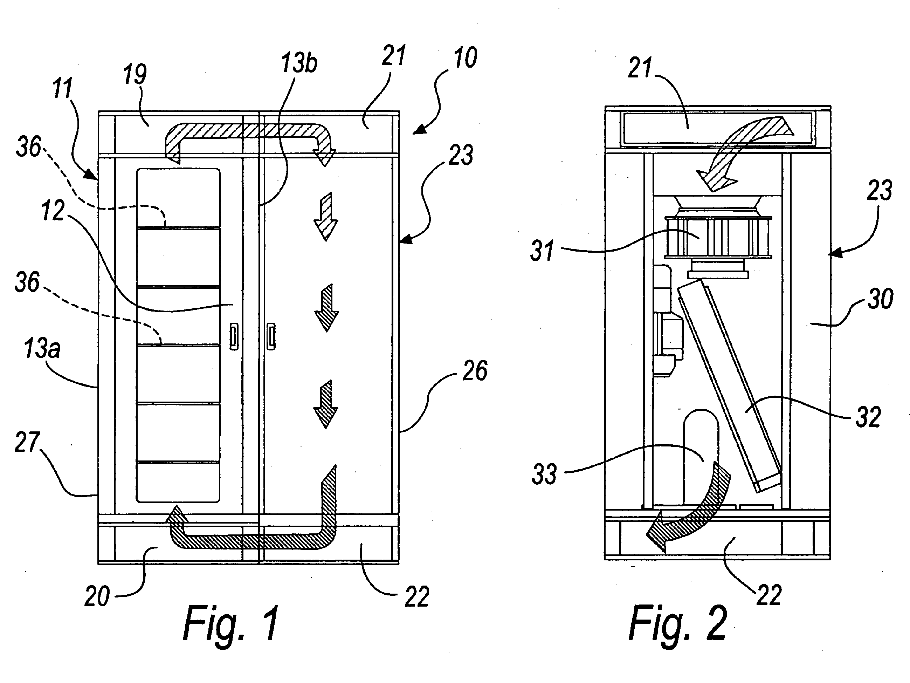

With reference to the figures, a conditioning apparatus particularly for racks for electrical, electronic, telecommunications instruments or the like according to the invention is generally designated by the reference numeral 10 in its first embodiment of Figure 1.

The apparatus 10 is constituted by a cabinet 11, which is formed by a door 12 for accessing its interior, two side walls 13a and 13b, and a back 14.

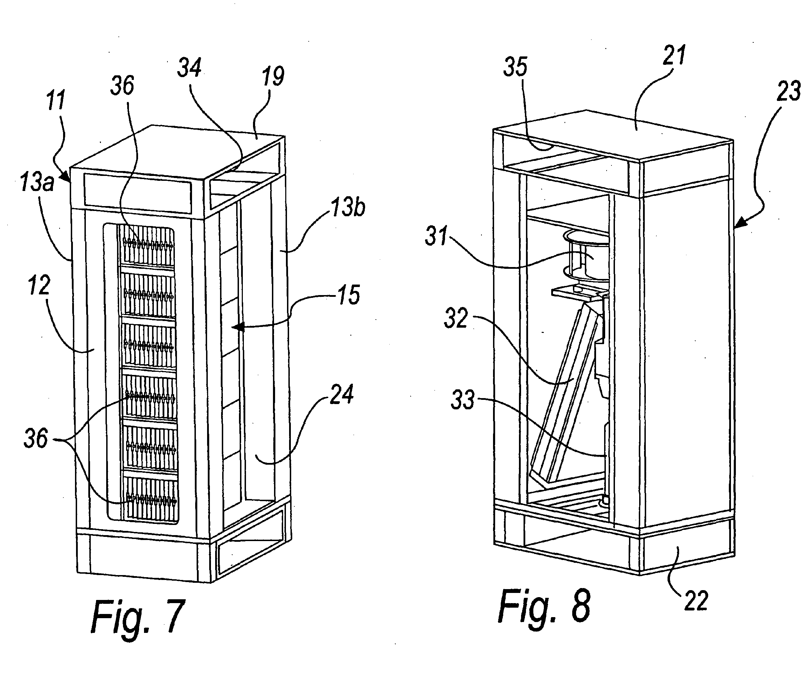

The cabinet 11, also shown in Figure 7, contains a rack chassis, designated by the reference numeral 15, for supporting electronic devices 36 and the like.

Air passage interspaces 16 and 17 are formed between the door 12 and the rack chassis 15 and between the back 14 and the rack chassis 15.

The cabinet 11 is open in an upper region onto a first air conveyance element 19 and in a lower region onto a second air conveyance element 20.

The first and second elements 19 and 20 in turn are connected respectively to a third conveyance element 21 and to a fourth conveyance element 22, which are arranged above and below an air-conditioning unit 23, which is shown in Figure 8.

The air-conditioning unit 23 is laterally adjacent to the cabinet 11 and is suitable to aspirate hot air from it and feed refrigerated air into it, along a path shown schematically in Figures 1, 2 and 3.

The upper air conveyance elements, the first one 19 and the third one 22, form a manifold for aspirating air from the inside of the cabinet 11, which contains the rack chassis 15, toward the air-conditioning unit 23.

The lower air conveyance elements, the second one 20 and the fourth one 22, form a manifold for feeding the air from the conditioning unit 23 into the cabinet 11 which contains the rack chassis 15.

Additional lateral air passage interspaces 24 are formed between the sides 13a and 13b of the cabinet 11 and the rack chassis 15.

The conditioning unit 23, inside the box-like body 30 which determines its volume, comprises a fan 31, which is arranged proximate to the third conveyance element 21, an evaporator 32, and a compressor 33.

The upper conveyance elements 19 and 21 are each constituted by a plenum which is open laterally onto the adjacent upper conveyance element.

The lower conveyance elements 20 and 22 are each constituted by a footing for resting on the ground, each one of said footings being open laterally onto the adjacent lower conveyance element.

The operation of an apparatus 10 according to the invention is as follows.

The instruments 36, by operating, heat the inside of the cabinet 11.

The apparatus 10 utilizes the physical principle of convection.

The hot air that arrives from the cabinet 11 through the two connected plenums (i.e., the upper conveyance elements 19 and 21) is aspirated by the fan 31, which sends it through the evaporator 32.

The stream of refrigerated air is sent at floor level, creating a region of colder air at the bottom and a warmer region at the top.

As mentioned, air is therefore aspirated in the warmer upper region, with the result of a higher efficiency of the cooling process and a consequent reduction of operating costs.

The refrigerated air then passes through the footings (the lower conveyance elements 22 and 20) and rises into the cabinet 11.

The footing 20 is structured so as to prevent the rise of the refrigerated air by means of the front interspace 16.

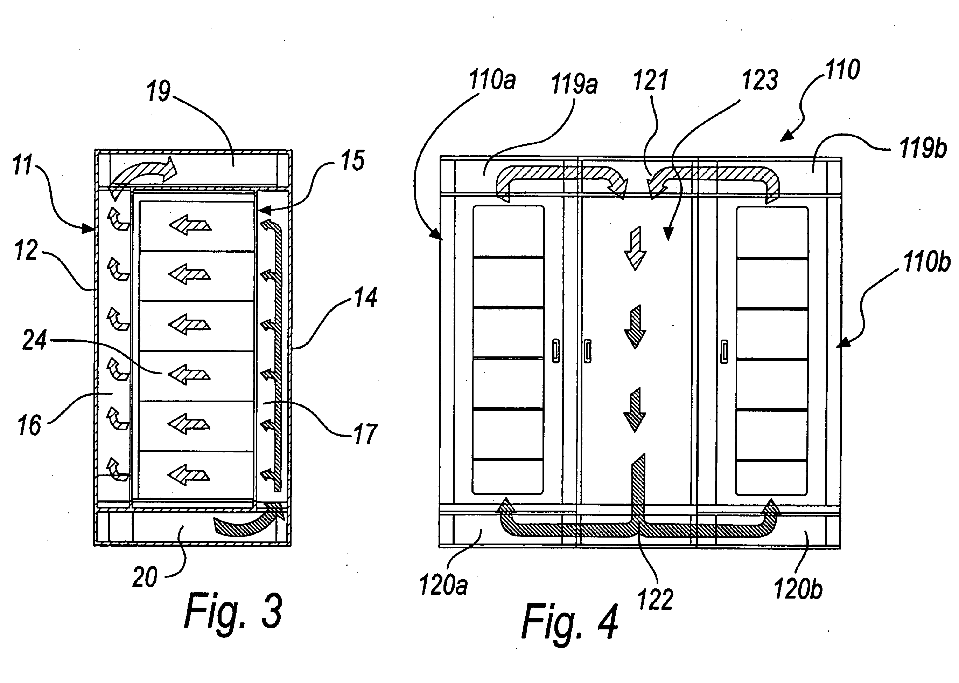

The refrigerated air then rises through the interspace 17, as illustrated in Figure 3.

The plenum 19 is instead open only at the front interspace 16, and therefore the air, in order to reach the upper conveyance element 19 (the plenum 19) passes through the cabinet 11, passing through the lateral interspaces 24, optimizing the removal of heat from the instruments 36.

The air, which at this point is heated, rises toward the first conveyance element 19 and then passes again, by means of the port 34 of said element, into the third conveyance element 21, also passing through the facing additional port 35 with which the element 21 is provided.

From the third conveyance element 21, the air resumes circulating, again by means of the fan 31.

The apparatus according to the invention is characterized in that it is modular and can be connected functionally, on one or both sides, generally designated by the reference numerals 26 and 27 in the figures, to at least one other identical apparatus.

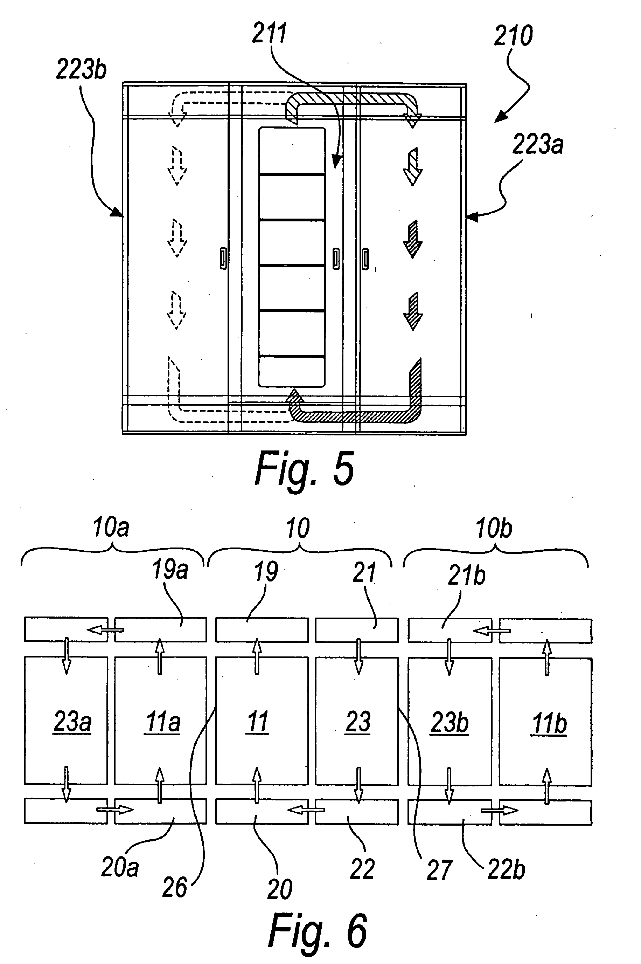

Figure 6 illustrates, by way of non-limiting example, a configuration in which there is a first central apparatus 10, which is functionally connected on one side to a second identical apparatus l0a and on the opposite side to a third identical apparatus 10b.

In this embodiment, the cabinets 11 and 11 a are arranged side-by-side and conditioning units 23a and 23b are likewise paired.

The first footings 20 and 22 are connected to the second footings 20a and 22a and the third footings 20b, 22b, and the same occurs likewise for the plenums.

In a second embodiment, shown schematically in Figure 4, the conditioning unit 123 of the apparatus 110 is in a central position, functionally connected on one side to a first cabinet 110a and on the other opposite side to a second cabinet 110b.

The conditioning unit 123 is provided, in an upper region, with a conveyance element 121, which is open on both sides connected to respective upper conveyance elements 119a and 119b of the two cabinets 110a and 110b, respectively.

Likewise, the conditioning unit 123 is provided, in a lower region, with an additional conveyance element 122, which is open on both sides connected to respective lower conveyance elements 120a and 120b.

Said second embodiment allows to refrigerate two cabinets with a single conditioning unit.

In a third embodiment of the invention, illustrated by way of example in Figure 5 and designated therein by the reference numeral 210, cabinet 211 has on either side a first conditioning unit 223a and a second auxiliary conditioning unit 223b, which are arranged side-by-side and functionally connected.

This embodiment is particularly suitable for racks in which electronic instruments are assembled, particularly instruments for telephony, which must absolutely not fail, and for which it is therefore more convenient to provide a redundant refrigeration system, so that temperature constancy can be ensured even if the main conditioning unit 223a fails.

The apparatus, in any one of the embodiments described above 10, 110, 210, can have the cabinet 11, 111 or 211 provided with security shutters which are suitable to place the rack chassis 15 in contact with the environment that surrounds the cabinet.

In case of malfunction of the apparatus, or if the external temperature is not such as to require the activation of the conditioning unit, by acting on said shutters it is possible to maintain an adequate temperature inside the cabinet by circulating inside it air which arrives from the room.

Better circulation of the refrigerated air, and accordingly the optimum even distribution of the temperature in the cabinet 11, is achieved if the interspaces 16 and 17 each have a depth (i.e., in the direction from the door 12 toward the back 14) which is substantially at least one quarter of the depth of the rack chassis 15.

In one example of embodiment of the invention, the depth of the rack chassis 15 is approximately 750 millimeters and the depth of the front and rear interspaces 16 and 17 is, for each one, approximately 200 millimeters.

In another constructive variation, the apparatus 10, 110, 210 according to the invention is characterized in that at least one among the front interspace 16, the rear interspace 17 and the lateral interspaces 24 are provided with a series of baffles suitable to direct the refrigerated air.

If the proportions in the direction of depth given above are not used, it is in fact advantageous to provide such baffles (not shown) so as to facilitate the distribution of the flow of air over all the surfaces of the instruments 36 supported by the rack 15.

In another constructive variation, the apparatus 10, 110, 210 has, on at least some of the upper conveyance elements 19, 21, 119a, 119b, 121 and lower conveyance elements 20, 22, 120a 12b, 122, shutters which are suitable to allow, modulate or inhibit the circulation of air.

The arrangement of the shutters on the conveyance elements instead of on the door and/or on the back of the cabinet as described previously allows to utilize ambient conditioning, keeping the temperature in the cabinet substantially constant and in fact facilitating the exchange of heat in the regions above or below the cabinet (i.e., in the conveyance elements) and preventing the air at ambient temperature from entering substantially directly onto the instruments enclosed in the cabinet, causing thereon thermal variations among their different regions.

In practice it has been found that the invention thus described solves the problems observed in known types of a conditioning apparatus particularly for racks for electrical, electronic, telecommunications instruments or the like.

In particular, by means of the present invention an apparatus has been provided which renders the correct operation of the instruments contained in a rack cabinet independent of the operation of the conditioning system of the surrounding room.

Moreover, the present invention provides a conditioning apparatus which, by way of its modularity, can be installed easily for a plurality of rack cabinets arranged in the vicinity of each other.

Further, by means of the present invention a conditioning apparatus has been provided which prevents the formation of regions which are stably too hot within a rack cabinet.

Not least, the present invention provides a conditioning apparatus which can be manufactured cheaply with known systems and technologies.

The invention thus conceived is susceptible of numerous modifications and variations, all of which are within the scope of the appended claims: all the details may further be replaced with other technically equivalent elements.

In practice, the materials employed, so long as they are compatible with the specific use, as well as the dimensions, may be any according to the requirements and the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A conditioning apparatus (10,110,210) particularly for racks for electrical, electronic, telecommunications instruments or the like, **characterized in that** comprises:
at least one cabinet (11), formed by at least one door (12) for accessing its interior, two side walls (13a,13b) and a back (14), said cabinet (11) containing a rack chassis (15) for supporting electronic devices (36) and the like, air passage interspaces (16,17) being formed between said at least one door (12) and the rack chassis (15) and between said back (14) and said rack chassis (15), said cabinet (11) being open in an upper region onto a first air conveyance element (19) and, in a lower region, onto a second air conveyance element (20), said air passage interspaces (16,17) being respectively connected to said first and second air conveyance elements (19,20);
a box-like body (30) containing an air conditioning unit (23) and including in an upper region a third air conveyance element (21) and in a lower region a fourth air conveyance element (22), said first and second elements (19,20) being in turn connected respectively to said third and fourth conveyance elements (21,22), which are arranged above and below an air-conditioning unit (23), said air conditioning unit (23) comprising a fan (31) which is arranged proximate to said third conveyance element (21), an evaporator (32), and a compressor (33), wherein the air conveyance elements (19,20,21,22) are open laterally, in order to connect said first air conveyance element (19) to said third air conveyance element (21) and said second air conveyance element (20) to said fourth air conveyance element (22) when said box-like body (30) is arranged laterally adjacent to said cabinet (11) and so that said air conditioning unit (23) aspirates hot air from it and feeds refrigerated air into it.

2. The apparatus according to claim 1, **characterized in that** said upper air conveyance elements, the first one (19) and the third one (21), form a manifold for aspirating air from the inside of the cabinet (11) which contains the rack chassis (15) toward said conditioning unit (23).

3. The apparatus according to one or more of the preceding claims, **characterized in that** said first (20) and fourth (22) lower air conveyance elements form a manifold for introducing air from the conditioning unit (23) into the cabinet (11) which contains the rack chassis (15).

4. The apparatus according to one or more of the preceding claims, **characterized in that** additional lateral interspaces (24) for the passage of air are formed between said sides (13a, 13b) of the cabinet (11) and the rack chassis (15).

5. The apparatus according to one or more of the preceding claims, **characterized in that** it is modular and can be functionally connected, on one or both of its sides (26, 27), to at least one other identical apparatus (10a, 10b).

6. The apparatus according to one or more of the preceding claims, **characterized in that** said conditioning unit (123) is functionally connected on one side to a first cabinet (110a) and, on the other opposite side, to a second cabinet (110b), said conditioning unit having, in an upper region, a conveyance element (121), which is open on both sides connected to the respective upper conveyance elements (119a, 119b) of the two cabinets (110a, 110b) and, in a lower region, an additional conveyance element (122), which is open on both sides connected to the respective lower conveyance elements (120a, 120b) of the two cabinets (110a, 110b).

7. The apparatus according to one or more of claims 1 to 5, **characterized in that** said cabinet (211) has a first conditioning unit (223a) and a second auxiliary conditioning unit (223b) arranged side-by-side and functionally connected on either side.

8. The apparatus according to one or more of the preceding claims, **characterized in that** said upper conveyance elements (19, 21, 119a, 119b, 121) are each constituted by a plenum which is open laterally onto at least one adjacent upper conveyance element.

9. The apparatus according to one or more of the preceding claims, **characterized in that** said lower conveyance elements (20, 22, 120a, 12b, 122) are each constituted by a footing for resting on the ground, each one of said footings being open laterally onto at least one adjacent lower conveyance element.

10. The apparatus according to one or more of the preceding claims, **characterized in that** said cabinet (11, 111, 211) is provided with safety shutters, which are suitable to place the rack chassis (15) in contact with the room that surrounds said cabinet (11, 111,211).

11. The apparatus according to one or more of the preceding claims, **characterized in that** said interspaces (16, 17) between at least one door (12) and the rack chassis (15) and between the back (14) and the rack chassis (15) each have a depth of substantially at least one quarter of the depth of said rack chassis (15).

12. The apparatus according to claim 11, **characterized in that** the depth of the rack chassis (15) is substantially at least 750 millimeters and the depth of the front and rear interspaces (16, 17) is substantially at least 200 millimeters for each interspace.

13. The apparatus according to one or more of claims 1 to 10, **characterized in that** at least one among the front interspace (16), the rear interspace (17) and the lateral interspaces (24) has a series of baffles which are suitable to direct the refrigerated air.

14. The apparatus according to one or more of the preceding claims, **characterized in that** at least some of the upper conveyance elements (19, 21, 119a, 119b, 121) and lower conveyance elements (20, 22, 120a, 12b, 122) for the air are provided with shutters in order to allow, modulate or inhibit air circulation.

## Patentansprüche

1. Eine Kilmaanlage (10, 110, 210), insbesondere für Gestelle für elektrische, elektronische, Telekommunikations-Geräte oder dergleichen, **dadurch gekennzeichnet, dass** sie Folgendes umfasst:
mindestens einen Schrank (11), gebildet durch mindestens eine Tür (12) für den Zugang zu seinem Inneren, zwei Seitenwände (13a, 13b) und eine Rückseite (14), wobei der Schrank (11) einen Gestellrahmen (15) zum Tragen elektronischer Geräte (36) und dergleichen enthält, wobei Luftdurchgangs-Zwischenräume (16, 17) zwischen der mindestens einen Tür (12) und dem Gestellrahmen (15) und zwischen der Rückseite (14) und dem Gestellrahmen (15) gebildet sind, wobei der Schrank (11) in einem oberen Bereich zu einem ersten Luftförderelement (19) hin und in einem unteren Bereich zu einem zweiten Luftförderelement (20) hin offen ist, wobei die Luftdurchgangs-Zwischenräume (16, 17) mit dem ersten beziehungsweise dem zweiten Luftförderelement (19, 20) verbunden sind,
einen kastenähnlichen Körper (30), der eine Klimaanlage-Einheit (23) enthält und in einem oberen Bereich ein drittes Luftförderelement (21) und in einem unteren Bereich ein viertes Luftförderelement (22) einschließt, wobei das erste und das zweite Element (19, 20) wiederum mit dem dritten beziehungsweise vierten Förderelement (21, 22) verbunden sind, welche über und unter einer Klimaanlage-Einheit (23) angeordnet sind, wobei die Klimaanlage-Einheit (23) Folgendes umfasst: einen Ventilator (31), der nahe dem dritten Förderelement (21) angeordnet ist, einen Verdunster (32) und einen Kompressor (33), wobei die Luftförderelemente, (19, 20, 21, 22) zur Seite hin offen sind, um das erste Luftförderelement (19) mit dem dritten Luftförderelement (21) und das zweite Luftförderelement (20) mit dem vierten Luftförderelement (22) zu verbinden, wenn der kastenähnliche Körper (30) seitlich neben dem Schrank (11) und so angeordnet ist, dass die Klimaanlage-Einheit (23) heiße Luft aus ihm absaugt und gekühlte Luft in ihn einführt.

2. Die Anlage gemäß Anspruch 1, **dadurch gekennzeichnet, dass** die oberen Luftförderelemente, das erste (19) und das dritte (21), ein Sammelrohr zum Ansaugen von Luft aus dem Inneren des Schranks (11), der den Gestellrahmen (15) enthält, zur Klimaanlage-Einheit (23) hin bilden.

3. Die Anlage gemäß einem oder mehreren der obigen Ansprüche, **dadurch gekennzeichnet, dass** das erste (20) und das vierte (22) untere Luftförderelement ein Sammelrohr zum Einführen von Luft aus der Klimaanlage-Einheit (23) in den Schrank (11) bilden, der den Gestellrahmen (15) enthält.

4. Die Anlage gemäß einem oder mehreren der obigen Ansprüche, **dadurch gekennzeichnet, dass** zusätzliche seitliche Zwischenräume (24) für den Durchlass von Luft zwischen den Seiten (13a, 13b) des Schranks (11) und dem Gestellrahmen (15) gebildet sind.

5. Die Anlage gemäß einem oder mehreren der obigen Ansprüche, **dadurch gekennzeichnet, dass** sie modular ist und funktionell auf einer oder auf beiden ihrer Seiten (26, 27) mit mindestens einer anderen identischen Anlage (10a, 10b) verbunden werden kann.

6. Die Anlage gemäß einem oder mehreren der obigen Ansprüche, **dadurch gekennzeichnet, dass** die Klimaanlage-Einheit (123) funktionell auf einer Seite mit einem ersten Schrank (110a) und auf der anderen, gegenüberliegenden, Seite mit einem zweiten Schrank (110b) verbunden ist, wobei die Klimaanlage-Einheit in einem oberen Bereich ein Förderelement (121) hat, das auf beiden Seiten, die mit den jeweiligen oberen Förderelementen (119a, 119b) der zwei Schränke (110a, 110b) verbunden sind, offen ist; und in einem unteren Bereich ein zusätzliches Förderelement (122), das auf beiden Seiten offen ist, die mit den entsprechenden unteren Förderelementen (120a, 120b) der beiden Schränke (110a, 110b) verbunden sind.

7. Die Anlage gemäß einem oder mehreren der Ansprüche 1 bis 5, **dadurch gekennzeichnet, dass** der Schrank (211) eine erste Klimaanlage-Einheit (223a) und eine zweite zusätzliche Klimaanlage-Einheit (223b) hat, die nebeneinander angeordnet und funktionell auf beiden Seiten verbunden sind.

8. Die Anlage gemäß einem oder mehreren der obigen Ansprüche, **dadurch gekennzeichnet, dass** die oberen Förderelemente (19, 21, 119a, 119b, 121) jeweils aus einer Plenumkammer bestehen, die seitlich zu mindestens einem angrenzenden oberen Förderelement hin offen ist.

9. Die Anlage gemäß einem oder mehreren der obigen Ansprüche, **dadurch gekennzeichnet, dass** die unteren Förderelemente (20, 22, 120a, 12b, 122) jeweils aus einem Sockel zum Stehen aus dem Boden bestehen, wobei jeder der Sockel seitlich zu mindestens einem benachbarten unteren Förderelement hin offen ist.

10. Die Anlage gemäß einem oder mehreren der obigen Ansprüche, **dadurch gekennzeichnet, dass** der Schrank (11, 111, 211) mit Schutzklappen ausgestattet ist, die geeignet sind, den Gestellrahmen (15) in Kontakt mit dem Raum zu bringen, der den Schrank (11, 111, 211) umgibt.

11. Die Anlage gemäß einem oder mehreren der obigen Ansprüche, **dadurch gekennzeichnet, dass** die Zwischenräume (16, 17) zwischen mindestens einer Tür (12) und dem Gestellrahmen (15) und zwischen der Rückseite (14) und dem Gestellrahmen (15) jeweils eine Tiefe von im Wesentlichen einem Viertel der Tiefe des Gestellrahmens (15) haben.

12. Die Anlage gemäß Anspruch 11, **dadurch gekennzeichnet, dass** die Tiefe des Gestellrahmens (15) im Wesentlichen mindestens 750 Millimeter beträgt und die Tiefe des vorderen und des hinteren Zwischenraums (16, 17) im Wesentlichen jeweils mindestens 200 Millimeter beträgt.

13. Die Anlage gemäß einem oder mehreren der Ansprüche 1 bis 10, **dadurch gekennzeichnet, dass** mindestens einer des vorderen Zwischenraums (16), des hinteren Zwischenraums (17) und der seitlichen Zwischenräume (24) eine Reihe von Ablenkblechen hat, die geeignet sind, die gekühlte Luft zu lenken.

14. Die Anlage gemäß einem oder mehreren der obigen Ansprüche, **dadurch gekennzeichnet, dass** mindestens einige der oberen Förderelemente (19, 21, 119a, 119b, 121) und der unteren Förderelemente (20, 22, 120a, 12b, 122) für die Luft mit Klappen ausgestattet sind, um Luftzirkulation zu ermöglichen, zu modulieren oder zu verhindern.

## Revendications

1. Dispositif de conditionnement d'air (10, 110, 210) en particulier pour des baies pour des instruments électriques, électroniques, de télécommunications ou similaires, **caractérisé en ce qu'**il comprend : au moins une armoire (11), formée par au moins une porte (12) pour accéder à son intérieur, deux parois latérales (13a, 13b) et une partie arrière (14), ladite armoire (11) contenant un châssis de baie (15) pour supporter le dispositif électronique (36) et similaire, les interstices de passage d'air (16, 17) étant formés entre ladite au moins une porte (12) et le châssis de baie (15) et entre ladite partie arrière (14) et ledit châssis de baie (15), ladite armoire (11) étant ouverte dans une région supérieure sur un premier élément de transport d'air (19) et dans une région inférieure, sur un deuxième élément de transport d'air (20), lesdits interstices de passage d'air (16, 17) étant respectivement raccordés auxdits premier et second éléments de transport d'air (19, 20) ;
un corps en forme de boîte (30) contenant une unité de conditionnement d'air (23) et comprenant dans une région supérieure, un troisième élément de transport d'air (21) et dans une région inférieure, un quatrième élément de transport d'air (22), lesdits premier et deuxième éléments (19, 20) étant à leur tour raccordés respectivement auxdits troisième et quatrième éléments de transport (21, 22), qui sont agencés au-dessus et au-dessous d'une unité de conditionnement d'air (23), ladite unité de conditionnement d'air (23) comprenant un ventilateur (31) qui est agencé à proximité dudit troisième élément de transport (21), un évaporateur (32) et un compresseur (33), dans lequel les éléments de transport d'air (19, 20, 21, 22) sont ouverts latéralement, afin de raccorder ledit premier élément de transport d'air (19) audit troisième élément de transport d'air (21) et ledit deuxième élément de transport d'air (20) audit quatrième élément de transport d'air (22) lorsque ledit corps en forme de boîte (30) est agencé latéralement de manière adjacente à ladite armoire (11) et de sorte que ladite unité de conditionnement d'air (23) aspire l'air chaud provenant de celui-ci et alimente l'air réfrigéré dans celui-ci.

2. Dispositif selon la revendication 1, **caractérisé en ce que** lesdits éléments de transport d'air supérieurs, le premier (19) et le troisième (21), forment un collecteur pour aspirer l'air provenant de l'intérieur de l'armoire (11) qui contient le châssis de baie (15) vers ladite unité de conditionnement (23).

3. Dispositif selon une ou plusieurs des revendications précédentes, **caractérisé en ce que** lesdits premier (20) et quatrième (22) éléments de transport d'air inférieurs forment un collecteur pour introduire l'air provenant de l'unité de conditionnement (23) dans l'armoire (11) qui contient le châssis de baie (15).

4. Dispositif selon une ou plusieurs des revendications précédentes, **caractérisé en ce que** des interstices latéraux supplémentaires (24) pour le passage de l'air sont formés entre lesdits côtés (13a, 13b) de l'armoire (11) et le châssis de baie (15).

5. Dispositif selon une ou plusieurs des revendications précédentes, **caractérisé en ce qu'**il est modulaire et peut être raccordé de manière fonctionnelle, sur l'un ou les deux de ses côtés (26, 27), sur au moins un autre dispositif identique (10a, 10b).

6. Dispositif selon une ou plusieurs des revendications précédentes, **caractérisé en ce que** ladite unité de conditionnement (123) est raccordée de manière fonctionnelle d'un côté à une première armoire (110a) et, de l'autre côté opposé, à une seconde armoire (110b), ladite unité de conditionnement ayant, dans une région supérieure, un élément de transport (121), qui est ouvert des deux côtés raccordés aux éléments de transport supérieurs (119a, 119b) respectifs des deux armoires (110a, 110b) et dans une région inférieure, un élément de transport supplémentaire (122) qui est ouvert des deux côtés raccordés aux éléments de transport inférieurs (120a, 120b) respectifs des deux armoires (110a, 110b).

7. Dispositif selon une ou plusieurs des revendications 1 à 5, **caractérisé en ce que** ladite armoire (211) a une première unité de conditionnement (223a) et une seconde unité de conditionnement auxiliaire (223b) agencées côte à côte et raccordées de manière fonctionnelle de chaque côté.

8. Dispositif selon une ou plusieurs des revendications précédentes, **caractérisé en ce que** lesdits éléments de transport supérieurs (19, 21, 119a, 119b, 121) sont chacun constitués par un plénum qui est ouvert latéralement sur au moins un élément de transport supérieur adjacent.

9. Dispositif selon une ou plusieurs des revendications précédentes, **caractérisé en ce que** lesdits éléments de transport inférieurs (20, 22, 120a, 12b, 122) sont chacun constitués par un piétement pour reposer sur le sol, chacun desdits piétements étant ouvert latéralement sur au moins un élément de transport inférieur adjacent.

10. Dispositif selon une ou plusieurs des revendications précédentes, **caractérisé en ce que** ladite armoire (11, 111, 211) comporte des obturateurs de sécurité, qui sont appropriés pour placer le châssis de baie (15) en contact avec la pièce qui entoure ladite armoire (11, 111, 211).

11. Dispositif selon une ou plusieurs des revendications précédentes, **caractérisé en ce que** lesdits interstices (16, 17) entre au moins une porte (12) et le châssis de baie (15) et entre la partie arrière (14) et le châssis de baie (15) ont chacun une profondeur représentant sensiblement au moins un quart de la profondeur dudit châssis de baie (15).

12. Dispositif selon la revendication 11, **caractérisé en ce que** la profondeur du châssis de bâti (15) est sensiblement d'au moins 750 millimètres et la profondeur des interstices avant et arrière (16, 17) est sensiblement d'au moins 200 millimètres pour chaque interstice.

13. Dispositif selon une ou plusieurs des revendications 1 à 10, **caractérisé en ce qu'**au moins l'un parmi l'interstice avant (16), l'interstice arrière (17) et les interstices latéraux (24) a une série de déflecteurs qui sont appropriés pour diriger l'air réfrigéré.

14. Dispositif selon une ou plusieurs des revendications précédentes, **caractérisé en ce qu'**au moins certains des éléments de transport supérieurs (19, 21, 119a, 119b, 121) et des éléments de transport inférieurs (20, 22, 120a, 12b, 122) pour l'air comportent des déflecteurs afin de permettre une circulation d'air modulée ou empêcher la circulation d'air.
